# EUROPÄISCHE PATENTSCHRIFT

(11) **EP 0 417 627 B1**
(45) Veröffentlichungstag und Bekanntmachung des Hinweises auf die Patenterteilung: **18.01.1995**
(21) Anmeldenummer: 90117058.9
(22) Anmeldetag: 05.09.1990
(51) Int. Cl.: C01G 3/00, C04B 35/00, H01L 39/24

(54) **Verfahren zur Herstellung eines Supraleiters**
Process for preparing a superconductor
Procédé de préparation d'un supraconducteur

(30) Priorität: 09.09.1989 DE 3930116
(43) Veröffentlichungstag der Anmeldung: 20.03.1991
(73) Patentinhaber: HOECHST AKTIENGESELLSCHAFT, 65926 Frankfurt am Main (DE)
(72) Erfinder: Jansen, Martin, Prof. Dr., D-5300 Bonn (DE); Bredthauer, Jörg, D-5300 Bonn (DE); Becker, Winfried, Dr., D-6233 Kelkheim (Taunus) (DE)

(56) Entgegenhaltungen:
- EP-A- 0 287 064
- EP-A- 0 303 249
- WO-A-88/10235
- SUPERCONDUCTOR SCIENCE AND TECHNOLOGY vol. 1, no. 3, 1988, BRISTOL, GB Seiten153 - 159; T. Yamamoto et al.: "Processing and microstructure of highlydense Ba2LnCu3O7 prepared from co-precipitated oxalate powder"

## Beschreibung

Die vorliegende Erfindung betrifft ein Verfahren zur Herstellung eines phasenreinen, Kupfer enthaltenden, oxidkeramischen Supraleiters, der neben Kupfer noch mindestens zwei Metalle ausgewählt aus der Gruppe Y, Ba, Ca, Sr, La, Tl, Pb oder der Seltenen Erden enthält, durch quantitative Copräzipitation der Metalloxalate aus entsprechend eingestellten Lösungen.

Die Herstellung von YBa₂Cu₃O₇₋ₓ-Keramiken wird erstmals in Physical Review Letters, Bd. 58 (1987), Seite 908 beschrieben. Nach diesem Verfahren werden die Ausgangsverbindungen Y₂O₃, BaCO₃ und CuO gut vermengt. Das Gemenge wird gepreßt, danach über mehrere Stunden bei 950°C gesintert und schließlich im Sauerstoffstrom langsam auf Raumtemperatur abgekühlt. In der Folge wurde gefunden, daß Sintertemperatur, Abkühlungsrate und Gasatmosphäre die physikalischen Eigenschaften des erhaltenen Körpers, insbesondere die für die Supraleitung verantwortlichen, erheblich beeinflussen.

Trotz großen experimentellen Aufwandes zur Optimierung der Darstellungsbedingungen ist die Situation hinsichtlich der Gewinnung phasenreiner Pulver oder Keramiken immer noch unbefriedigend. Als häufigste Nebenphasen wurden BaCuO₂, Y₂BaCuO₅ und CuO für YBa₂Cu₃O₇₋ₓ identifiziert. Ahnliche Probleme bestehen auch bei der Herstellung anderer Kupfer enthaltender oxidkeramischer Supraleiter.

Um örtliche Inhomogenitäten zu vermeiden, die sich möglicherweise durch Sintern der Oxide nicht genügend beseitigen lassen, hat man schon versucht, metallhaltige Ausgangsmaterialien durch Copräzipitation zu erhalten.

Aus EP 303 249 ist ein Verfahren zur Herstellung von YBa₂Cu₃Oₓ-Supraleitern bekannt, bei dem man eine wäßrige Lösung, die die Nitrate von Y, Ba und Cu im Atomverhältnis von Y:Ba:Cu = 1:2:3 enthält, mit Oxalat ausfällt. Das Oxalat wird isoliert und zunächst bei 700°C bei einem Sauerstoff-partialdruck von 0,01 Torr und dann als Formkörper bei 850°C oder 900°C in Sauerstoff gebrannt. Dabei können bei Co-Präzipitaten, die aus wäßriger Lösung gefällt werden, wegen der in der Regel unterschiedlichen Löslichkeiten der ausgefällten Salze im Wasser Schwierigkeiten auftreten (Solid State Communications Bd. 64 (1987), Seite 881).
Gemäß US-Patent 4 804 649 wird durch Copräzipitation aus einer wäßrigen Lösung, die Salze von Y, Ba und Cu enthält, mit alkalischer Oxalatlösung ein basisches Oxalat erhalten. Aber auch hier können die zu Beginn der Fällung und bei Ende der Fällung entstehenden Oxalate unterschiedliche Kationen-Verhältnisse aufweisen, so daß beim Tempern des Produktes u.a. geringe Mengen an BaCuO₂ und Y₂BaCuO₅ auftreten können. Ferner ist bei diesem Verfahren das restlose Auswaschen von überschüssiger Natronlauge nicht ganz einfach.

Aus EP 287 064 geht hervor, daß man zur Herstellung von Hochtemperatur-Supraleitern lösliche Metallsalze in Gegenwart von Alkohol mit einer Oxalsäure-Lösung vereinigt hat, wobei die Metalle als Oxalat ausgefällt, sodann die Oxalate abgetrennt, getrocknet, im Sauerstoffstrom bei 800 - 1200°C bis zur thermischen Zersetzung erhitzt und anschließend in Gegenwart von Sauerstoff unter Bildung des Supraleiters erhitzt wurden.

Nachteilig ist, daß Oxidpulver, die bei derart hohen Temperaturen gewonnen werden, nicht sehr sinteraktiv sind.

Es bestand daher die Aufgabe, einen Kupfer enthaltenden oxidkeramischen Supraleiter, insbesondere auf Basis von YBa₂Cu₃O₇₋ₓ aus einem Ausgangsmaterial herzustellen, bei dem die bekannten Atomverhältnisse der Metalle genau eingehalten werden, und das besonders sinteraktiv ist.

Gelöst wird diese Aufgabe durch ein Verfahren gemäß Patentanspruch 1, dessen nähere Ausgestaltungen in den Unteransprüchen 2 bis 7 dargestellt sind.

Das angegebene Verfahren eignete sich insbesondere zur Herstellung oxidkermaischer Supraleiter, die kein Wismut enthalten, vorzugsweise zur Herstellung von YBa₂Cu₃O_{Z}, aber auch für LaBa₂Cu₃O_{Z}, LnBa₂Cu₃O_{Z} (wobei Ln für ein Element der Seltenen Erden steht), Y₁₋ₓCaₓBa₂Cu₃O₇, YSr₂Cu₃O₇, La₁₊ₓBa₂₋ₓCu₃O₇, La₂₋ₓSrₓCuO₄, Ln₂₋ₓCeₓCuO₄, Tl₂Ba₂CaCuO₈, Tl₂Ba₂Ca₂Cu₃O₁₀, Tl₂Ba₂₋ₓSrₓCaCu₂O₈, TlBa₂Cu₃O₉, Pb₂Sr₂Ca₁₋ₓYₓCu₃O₈.

Erfindungsgemäß soll man eine wäßrige Lösung einsetzen, die die Metallkationen enthält, beispielsweise eine Lösung von YCl₃, CuCl₂, und Ba(ClO₄)₂, und in der Siedehitze mit einer Lösung der Oxalsäure in einem mit Wasser mischbaren organischen Lösemittel vereinigen und dadurch die Oxalate ausfällen. Als Salze eigenen sich, je nach Löslichkeit, z.B. die Chloride, Sulfate, Zitrate oder Nitrate. Die Konzentration der Oxalsäure beträgt ca. mindestens 10 g/l, vorzugsweise mindestens 30 g/l.

Der entstandene hellblaue Niederschlag wird zunächst mit kaltem, mit Wasser mischbaren organischen Lösemittel, beispielsweise Ethanol, gewaschen und getrocknet. Die thermische Zersetzung erfolgt bei Temperaturen von 200 bis 400°C im Sauerstoff-Strom. Die anschließende Reaktion zum Supraleiter, bei gepreßten Formkörpern unter Sintern, erfolgt bei 900 bis 950°C, vorzugsweise bei 920 bis 930°C, im Sauerstoffstrom. Das Sintern eines Preßkörpers aus YBa₂Cu₃O₉ setzt nach dilatometrischen Untersuchungen bei 800°C ein, d.h. um 100 K tiefer als bei herkömmlichen Proben.

Es hat sich gezeigt, daß aus einem Ba enthaltenden Oxalat, das z.B. zur Herstellung von YBa₂Cu₃O₇₋ₓ dient, während der thermischen Zersetzung bei hohem O₂-Partialdruck (mindestens 200 mbar O₂) Bariumcarbonat gebildet wird. Es ist dann erforderlich, längere Zeit zu erhitzen, um das gesamte Carbonat in Oxid und schließlich bei der eigentlichen Reaktion in den Supraleiter zu überführen.

Diese Zersetzung des Carbonats dauert bei 900°C mindestens 24 Stunden, bei 800°C mindestens 72 Stunden. Noch besser ist ein Sintern bei 900 bis 950°C während mindestens 50 Stunden.

Die nach dem angegebenen Verfahren synthetisierten Supraleiter-Pulver wurden mit röntgenographischen Pulvermethoden und analytischer Gehaltsbestimmung mit Hilfe der Mikrosonde als phasenrein identifiziert. Sie sind sehr feinkörnig. Ihre Primärteilchengröße liegt unter 1 »m.

Die Erfindung wird durch die folgenden Beispiele näher erläutert:

### Beispiel 1

Aus den Ausgangsverbindungen Ba(NO₃)₂, Cu(NO₃)₂·3H₂O und Y₂O₃ (nach Überführung in Y(NO₃)₃·5H₂O) werden getrennte 0,2-molare wäßrige neutrale Lösungen hergestellt. Die wäßrigen Lösungen von Y³⁺ Ba²⁺ und Cu²⁺ werden im Verhältnis 1:2:3 gemischt und in der Siedehitze mit einer 7 %igen Lösung von Oxalsäure in Ethanol gefällt.

Der hellblaue Niederschlag wird mit kaltem Ethanol gewaschen und anschließend getrocknet. Die thermische Behandlung erfolgt in 4 Schritten. Zunächst wird bei 250°C das Kristallwasser entfernt und danach das trockene Oxalat im O₂-Strom 6 Stunden bei 500°C zersetzt. Das anfallende Pulver wird mit einer Kraft von 20 t zu Tabletten gepreßt und diese bei 920 - 930°C 7 Tage im O₂-Strom gesintert. Danach wird kontrolliert mit einer Rate von 0,8°C/min auf 450°C abgekühlt, bei dieser Temperatur 18 Stunden belassen und wiederum mit 0,8°C/min (O₂-Strom) auf Raumtemperatur abgekühlt.

Man erhält schwarze, harte Preßlinge mit einem T_{c} von 92 K aus YBa₂Cu₃O₇₋ₓ, in denen sich keine Nebenprodukte identifizieren lassen. Die Stromtragfähigkeit bei 77 K und 0 Gauss beträgt 560 A/cm². Der supraleitende Anteil macht ca. 100 % aus (Shielding-Effekt).

## Patentansprüche

1. Verfahren zur derstellung eines Kupfer und Barium enthaltenden oxidkeramischen Supraleiters, wobei man eine wäßrige Lösung bereitet, die die Metallanteile des Supraleiters in den für diesen berechneten Mengenverhältnissen in Form löslicher Salze enthält, man durch Vereinigung mit einer Oxalsäurelösung in Gegenwart eines mit Wasser mischbaren organischen Lösemittels die Metalle als Oxalat ausfällt, man das Oxalat abtrennt, trocknet, im Sauerstoffstrom bis zur thermischen Zersetzung erhitzt und anschließend das durch thermische Zersetzung der Oxalate anfallende Pulver im Sauerstoffstrom bei Temperaturen von 800 - 930°C unter Bildung des Supraleiters erhitzt und abkühlt, dadurch gekennzeichnet, daß man das pulverförmige Oxalat bei Temperaturen von 200 - 500°C thermisch zersetzt und daß man in der Siedehitze ausfällt.

2. Verfahren nach Anspruch 1, dadurch gekennzeichnet, daß der herzustellende Supraleiter neben Kupfer und Barium noch mindestens ein Metall der Gruppe Y, Ca, Sr, La, Tl, Pb oder der seltenen Erden enthält.

3. Verfahren nach Anspruch 2, dadurch gekennzeichnet, daß man eine Metallsalzlösung mit einem Atomverhältnis (Y, La, SE):(Ba,Sr): Cu von 1:2:3 einsetzt, wobei SE für die seltenen Erden steht.

4. Verfahren nach Anspruch 3, dadurch gekennzeichnet, daß man eine Metallsalzlösung einsetzt, die Ionen von Y³⁺, Ba²⁺ und Cu²⁺ im Atomverhältnis 1:2:3 enthält.

5. Verfahren nach Anspruch 1, dadurch gekennzeichnet, daß das organische Lösemittel aus mindestens einer der Verbindungen Methanol, Ethanol und Aceton besteht.

6. Verfahren nach Anspruch 1, dadurch gekennzeichnet, daß man das durch thermische Zersetzung des Oxalats gewonnene Pulver zu Formkörpern verpreßt und diese bei Temperaturen von 900 - 950°C, insbesondere 920 - 930°C, für mindestens 25 Stunden im Sauerstoffstrom sintert.

7. Verfahren nach Anspruch 6, dadurch gekennzeichnet, daß man einen Formkörper aus gesintertem Material für mindestens 5 Stunden bei Temperaturen von 400 - 500°C in Sauerstoffatmosphäre tempert.

## Claims

1. A process for the preparation of a copper- and barium-containing, ceramic oxide superconductor in which an aqueous solution is prepared which contains, in the form of soluble salts, the metal components of the superconductor in the ratios calculated for the latter, the metals are precipitated as oxalates by combining this solution with an oxalic acid solution in the presence of a water-miscible organic solvent, the oxalates are separated off, dried and heated in a stream of oxygen until thermal decomposition, and the powder formed by thermal decomposition of the oxalates is subsequently heated at a temperature of 800-930°C in a stream of oxygen to form the superconductor and cooled, wherein the pulverulent oxalates are thermally decomposed at temperatures of 200-500°C and wherein the precipitation is carried out at the boiling point.

2. The process as claimed in claim 1, wherein the superconductor to be prepared contains, besides copper and barium, at least one metal from the group consisting of Y, Ca, Sr, La, Tl, Pb and the rare earths.

3. The process as claimed in claim 2, wherein a metal salt solution having an atomic ratio (Y, La, Re):(Ba, Sr):Cu of 1:2:3 is employed, where Re denotes the rare earths.

4. The process as claimed in claim 3, wherein a metal salt solution is employed which contains ions of Y³⁺, Ba²⁺ and Cu²⁺ in the atomic ratio 1:2:3.

5. The process as claimed in claim 1, wherein the organic solvent comprises at least one of the compounds methanol, ethanol and acetone.

6. The process as claimed in claim 1, wherein the powder obtained by thermal decomposition of the oxalates is pressed to form moldings, and the latter are sintered at temperatures of 900-950°C, in particular 920-930°C, for at least 25 hours in a stream of oxygen.

7. The process as claimed in claim 6, wherein a molding of sintered material is conditioned for at least 5 hours at temperatures of 400-500°C in an oxygen atmosphere.

## Revendications

1. Procédé de préparation d'un supraconducteur formé par, ou comportant, des oxydes céramiques et contenant du cuivre et du baryum, procédé selon lequel on prépare une solution aqueuse qui contient, selon les rapports entre les quantités calculées pour ces taux et sous forme de sels solubles, la fraction métallique du supraconducteur; on précipite, par combinaison avec une solution d'acide oxalique en présence d'un solvant organique miscible à l'eau, les métaux sous forme d'oxalate(s), on sépare le ou les oxalate(s), on le sèche, on le chauffe dans un courant d'oxygène jusqu'à décomposition thermique, puis on soumet la poudre, obtenue par la décomposition thermique des oxalates à un chauffage dans un courant d'oxygène à des températures de 800-930°C avec formation du supraconducteur et l'on refroidit, procédé caractérisé en ce qu'on soumet à décomposition thermique à des températures de 200-500°C l'oxalate pulvérulent et l'on effectue une précipitation à la chaleur de l'ébullition.

2. Procédé selon la revendication 1, caractérisé en ce que le supraconducteur à préparer contient, en plus du cuivre et du baryum, au moins encore un métal choisi dans l'ensemble formé par Y, Ca, Sr, La, Tl, Pb ou les terres rares.

3. Procédé selon la revendication 2, caractérisé en ce qu'on utilise une solution de sels de métaux présentant un rapport entre les atomes (Y, La, TR): (Ba, Sr):Cu de 1:2:3, l'abréviation TR représentant les terres rares.

4. Procédé selon la revendication 3, caractérisé en ce qu'on utilise une solution de sels de métaux qui contient les ions de Y³⁺, de Ba²⁺ et de Cu²⁺ selon un rapport atomique de 1:2:3.

5. Procédé selon la revendication 1, caractérisé en ce que le solvant organique consiste en au moins l'un des composés : méthanol, éthanol et acétone.

6. Procédé selon la revendication 1, caractérisé en ce qu'on presse la poudre, obtenue par décomposition thermique de l'oxalate pour obtenir des corps moulés ou façonnés et l'on soumet ces corps, à des températures de 900-950°C, en particulier 920 à 930°C, pendant 25 heures au moins à du frittage dans un courant d'oxygène.

7. Procédé selon la revendication 6, caractérisé en ce qu'on soumet un corps moulé ou façonné en une matière frittée, à un maintien de tempérage durant 5 heures au moins à des températures de 400-500°C en atmosphère d'oxygène.
